**Europäisches Patentamt**

**European Patent Office**

**Office européen des brevets**

(11) Publication number: **0 077 004**
**B1**

## (12) EUROPEAN PATENT SPECIFICATION

(45) Date of publication of patent specification: **07.02.90**

(21) Application number: **82109195.6**

(22) Date of filing: **05.10.82**

(51) Int. Cl.⁵: **H 01 L 29/06, H 01 L 29/86**

(54) **Semiconductor rectifier diode.**

(30) Priority: **07.10.81 JP 158758/81**

(43) Date of publication of application:
**20.04.83 Bulletin 83/16**

(45) Publication of the grant of the patent:
**07.02.90 Bulletin 90/06**

(84) Designated Contracting States:
**DE NL**

(56) References cited:
**EP-A-0 030 370**
**DE-A-2 457 106**
**FR-A-2 456 389**

The file contains technical information
submitted after the application was filed and
not included in this specification

(73) Proprietor: **Hitachi, Ltd.**
**5-1, Marunouchi 1-chome**
**Chiyoda-ku Tokyo 100 (JP)**

(72) Inventor: **Terasawa, Yoshio**
**622-19, Ichige**
**Katsuta-shi Ibaraki-ken (JP)**
Inventor: **Shimizu, Yoshiteru**
**3600-119, Nakane**
**Katsuta-shi Ibaraki-ken (JP)**
Inventor: **Naito, Masayoshi**
**3449-5, Higashiishikawa**
**Katsuta-shi Ibaraki-ken (JP)**
Inventor: **Murakami, Susumu**
**434-161, Ishinazaka-cho**
**Hitachi-shi Ibaraki-ken (JP)**

(74) Representative: **Patentanwälte Beetz sen. -**
**Beetz jun. Timpe - Siegfried - Schmitt-Fumian**
**Steinsdorfstrasse 10**
**D-8000 München 22 (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

The present invention relates to a semiconductor rectifier diode.

In recent years, introductions of ICs of LSIs are abruptly advancing into electronic computers, their various terminal devices or various system devices. A low-voltage d.c. stabilized power source is required as one for those devices. In order to obtain a low-voltage stabilized direct current from a commercial power source, there are a variety of methods, of which a switching regulator system having advantages of small size and high efficiency is excellent.

A rectifier diode to be used in the aforementioned power source is required to have a low loss, stability and a high speed. These characteristics have not been satisfied by the diodes which are well known in the art. For example, the Shottky barrier diode, as is disclosed in JP—A—55-107272 (1980), has had defects that the leakage current in the backward direction is high and that it is thermally unstable.

On the other hand, the junction diode of p-i-n type according to the prior art has had a defect that its loss is not sufficiently low. In this p-i-n type diode, moreover, in order to enhance the low-loss character, there has been proposed an improvement for extremely reducing the thickness of the p- or ń-type layer, as has been disclosed in IEEE Transactions on Electron Devices", Vol. ED-23, No. 8, August 1976, p. 945—949. Likewise the Shottky barrier diode, the p-i-n type diode has had defects that it is difficult in production and bad in blocking voltage, yield and evenness.

Further, the FR—A—2456389 discloses a semiconductor rectifier diode having the features indicated in the preamble part of claim 1 of the present invention; but since the second main electrode thereof is a P⁺ semiconductor layer forming potential barriers by contacting the third and fourth semiconductor layers and one of the outer periphery side ends of the third semiconductor layer is in direct contact with the fourth semiconductor layer, the forward voltage drop is relatively high, the reverse recovery time is relatively long, and a high blocking voltage cannot be obtained.

It is, therefore, an object of the present invention to provide a semiconductor rectifier diode which has an improved structure freed from the aforementioned defects.

Another object of the present invention is to provide a semiconductor rectifier diode which has such an improved structure as is easy in production and as is excellent in the low-loss, stability and· high-speed characteristics. Said objects are achieved, according to the present invention, by a semiconductor rectifier diode comprising a semiconductor substrate having first and second major surfaces, positioned at opposite sides of said substrate, including a first semiconductor layer of n-conductivity type disposed adjacent to said first major surface, a second semiconductor layer of the n-conductivity type disposed adjacent to said first semiconductor layer and having a lower impurity concentration than said first semiconductor layer, a third semiconductor layer of a p conductivity type disposed adjacent to a selected portion of said second semiconductor layer and formed in said second major surface, said third semiconductor layer further having a higher impurity concentration than said second semiconductor layer, and at least one fourth semiconductor layer of the p conductivity type disposed adjacent to said second semiconductor layer and formed in said second major surface, having a smaller thickness in a direction normal to said second major surface of said substrate than said third semiconductor layer and having higher impurity concentration than said second semiconductor layer and a lower impurity concentration than said third semiconductor layer;

said fourth semiconductor layer and those portions of said first and second semiconductor layers, which overlap said fourth semiconductor layer in the direction normal to said major surfaces construct a major current passage, a first main electrode disposed at said first major surface and ohmically contacting with said first semiconductor layer, and a second main electrode disposed at said second major surface and ohmically contacting with said third semiconductor layer and said fourth semiconductor layer characterized in that said fourth semiconductor layer is surrounded by said third semiconductor layer and has a width such that the depletion layer extending mainly from a pn junction between said third semiconductor layer and said second semiconductor layer pinches off said main current passage when a negative voltage is applied to said second main electrode relative to said first main electrode.

Preferably said fourth semiconductor layer has a plurality of stripes juxtaposed in one direction.

Fig. 1 is a schematic perspective view showing one embodiment of the present invention;

Fig. 2 is an enlarged sectional view showing a portion of Fig. 1;

Fig. 3 is a graphical presentation illustrating the impurity concentration distribution of the embodiment shown in Figs. 1 and 2; and

Figs. 4 to 10 are graphical presentations illustrating the characteristic curves for explaining the characteristics of the embodiment shown in Figs. 1 and 2.

The present invention will be described in detail in the following with reference to the accompanying drawings.

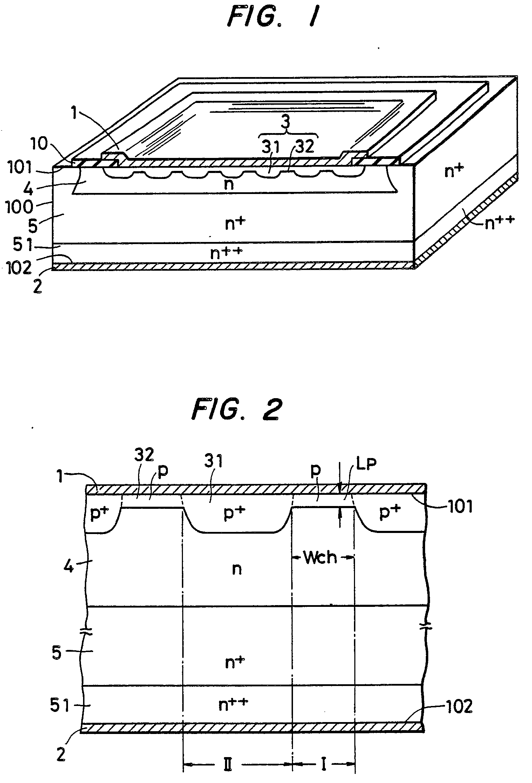

Fig. 1 shows the overall construction and the section of a diode according to one embodiment of the present invention, and Fig. 2 is an enlarged view showing an essential portion in section. As shown, a semiconductor substrate 100 formed with a pair of main surfaces 101 and 102 has such a laminated structure between the paired main surfaces as is composed in succession of an n⁺⁺-type layer 51, an n⁺-type layer 5, an n-type layer 4 and a p-type layer 3. This p-type layer 3 is so formed that first p-type layer portions 31 having a higher concentration and made thicker and second p-type layer portions 32 having a lower concentration and made thinner than the p-type layer portions 31 are arrayed alternately in respective stripe shapes. The second p-type layer portions 32 are substantially surrounded by the first p-type layer portions 31. Figs. 1 and 2 provide sections which are taken in directions perpendicular to the longitudinal directions of those stripe shapes. In Fig. 2, numerals I and II indicate first and second laminated structures, respectively.

The p-type layer 3 has its terminal end exposed to the one main surface 101. On the other hand, the $n^+$-layer 5 is exposed at the peripheral edge of the semiconductor substrate to the one main surface 101. At the boundary between the p-type layer 3 and the n-type layer 4, there is formed a pn junction which terminates at the one main surface.

At the exposed portion of the pn junction at the one main surface, there is formed a $SiO_2$ film 10 for protecting that junction. At the exposed portion of the p-type layer 3, on the other hand, there is formed an anode 1 which is made to ohmically contact with the p-type layer 3.

The other main surface 102 of the semi-conductor substrate is formed with a cathode 2 which is made to ohmically contact with the $n^{++}$-type layer 51. In case the $n^+$-type layer 5 has a high impurity concentration, the $n^{++}$-type layer 51 may be omitted, and the cathode 2 may be directly made to ohmically contact with the $n^+$-type layer 5.

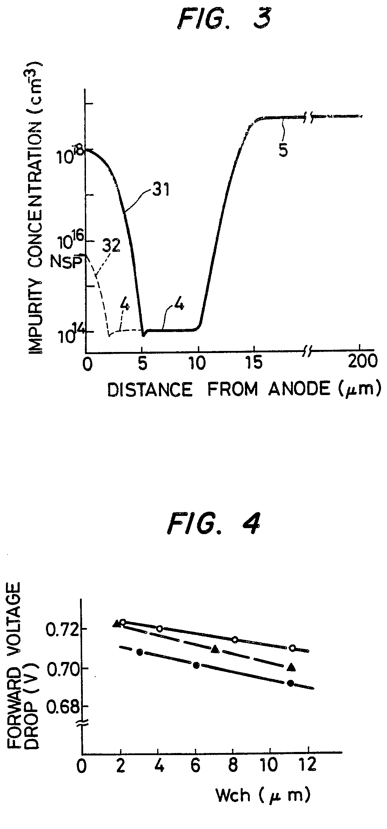

The impurity concentration distribution of the first laminated structure in a direction normal to the main surfaces is plotted in a solid line in Fig. 3, whereas the impurity concentration distribution of the second laminated structure in the same direction as above is plotted in a broken line in the same Figure.

The semiconductor substrate of the diode according to the present embodiment is sized to be a square having one side of about 4 mm. The diode of the present embodiment can be fabricated by making use of the well-known semiconductor device fabricating technique. The summary of one example will be described in the following.

First of all, an $n$-$n^+$-type silicon wafer is prepared. Phosphor is diffused selectively into one of the main surfaces of the wafer and wholly into the other main surface to form both the exposed portion of the $n^+$-type layer 5 to the one main surface 101 and the $n^{++}$-type layer 51. Next, boron is selectively diffused into the one main surface to form the first p-type layer portion 31. Subsequently, boron ions are implanted into the one main surface, and a heat treatment is executed to form the second p-type layer portion 32. Next, the paired main surfaces have their predetermined portions vacuum-evaporated with Al or a laminated film of Cr-Ni-Ag, for example, to form the anode 1 and the cathode 2. Incidentally, the $SiO_2$ film is either formed as a result of the oxidization of silicon during the aforementioned heat treatment such as a diffusion process or deposited by another CVD method.

The operations and effects of the diode thus fabricated will be described in the following. Likewise the existing pn junction diode, a main current flows between the paired main electrodes in a state (i.e., a forward bias state), in which a positive voltage is applied to the anode 1 relative to the cathode 2, but is blocked in a state (i.e., in a backward bias state) in which a negative voltage is applied to the anode 1 relative to the cathode 2. The main current passage is established mainly in the $p$-$n$-$n^+$-$n^{++}$ diode region (i.e., the first laminated structure), including the second p-type layer portion 32. During the backward or reverse bias, on the other hand, a depletion layer is formed even at the pn junction between the second p-type layer portion 32 and the n-type layer 4, but the depletion layer extending mainly from the pn junction between the first p-type layer portion 31 and the n-type layer 4 pinches off the main current passage to block the main current and to bear the blocking voltage during the reverse bias. Thus, during the forward bias, the second p-type layer portion 32 having a lower concentration and made thinner acts as a anode (or emitter) region to invite advantages such as a low loss and a high speed. During the backward bias, on the other hand, the first p-type layer portion 31 made thicker bears the blocking voltage to invite advantages such as a high blocking voltage and stable characteristics. Moreover, since the depletion layer for pinching off the main current passage is formed of not the thinner second p-type layer portion 32 but the thicker first p-type layer portion 31, the design of the second p-type layer portion 32 of the main current passage can be advantageously conducted exclusively from the standpoint such as the low loss or the high speed, which is contrary to the high blocking voltage. Even if the second p-type layer portion 32 has defects such as pin holes, furthermore, there can be attained an effect that the reverse blocking voltage is not dropped. As a result, the production yield is enhanced.

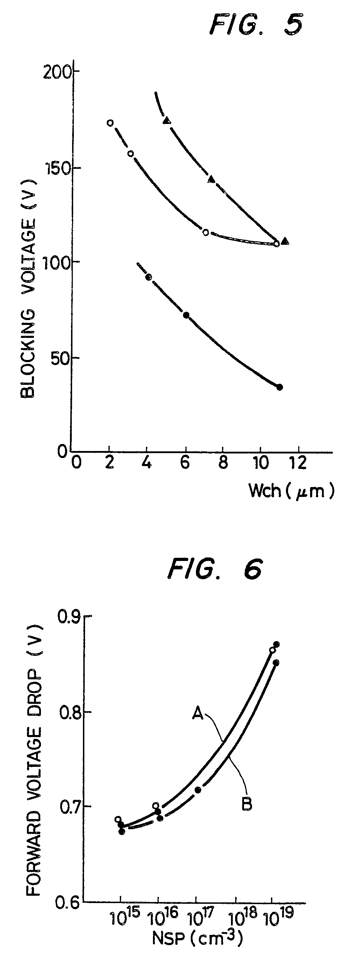

Fig. 4 plots the forward voltage drop of the p-type layer portion 32 of the diode of the present embodiment against a width Wch, and Fig. 5 plots the blocking voltage against the width Wch. Here, those Figures correspond to the case in which: the current density is about 60 $A/cm^2$; the thickness Lp of the second p-type layer portion 32 is 2 μm; the thickness of the first p-type layer portion 31 is 5 μm; and the thickness of the n-type layer 4 between the bottom of the first p-type layer portion 31 and the $n^+$-type layer 5 is 5 μm. Symbols ▲, o and ● appearing in those Figures correspond to the cases in which the impurity concentration Nn of the n-type layer 4 and the surface impurity concentration Nsp of the second p-type layer portion 32 at the one main surface 101 take such values as are tabulated in the following Table 1:

## TABLE 1

| Symbols | Nn(cm$^{-3}$) | Nsp(cm$^{-3}$) |
|---------|---------------|----------------|
| ▲ | $3\times10^{13}$ | $5\times10^{15}$ |
| o | $1\times10^{14}$ | $5\times10^{15}$ |
| ● | $3\times10^{13}$ | $1\times10^{15}$ |

In view of Figs. 4 and 5, it is found that the forward voltage drop is merely increased by about 0.02 V but the blocking voltage can be raised by about 70 V by reducing the width of the second p-type layer portion 32 from about 10 μm to about 2 μm, for example, even if the second p-type layer portion 32 has the low surface impurity concentration of $5\times10^{15}$ cm$^{-3}$ and the small thickness of 2 μm.

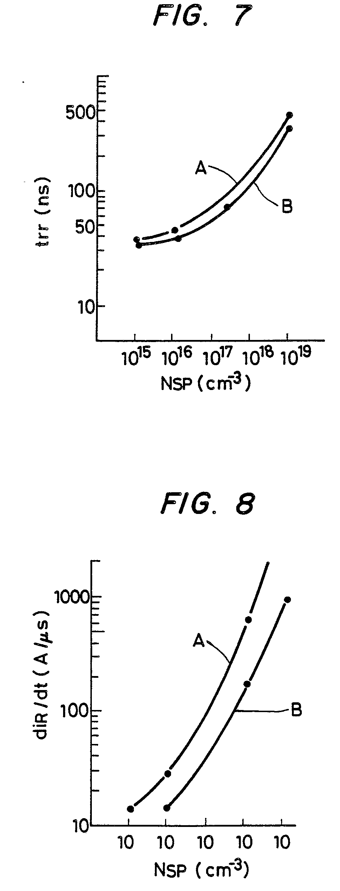

Next, the influences of the surface impurity concentration of the second p-type layer portion 32 upon the characteristics of the diode of the present embodiment will be described in the following. Figs. 6, 7 and 8 plot the forward voltage drop, the backward restoration time $t_{rr}$ and the reduction rate $di_R/dt$ of the backward restoration current, respectively, in case the thickness Lp of the second p-type layer portion 32 is 1 to 2 μm whereas the impurity concentration Nn of the n-type layer 4 is $1\times10^{14}$ to $1\times10^{15}$ cm$^{-3}$. Those plots correspond to the case in which the forward current density is about 60 A/cm$^2$ and the forward current reduction rate during the backward restoration is 30 A/μs. Here, the thickness Lp and the impurity concentration Nn of those respective Figures take such values as are tabulated in Table 2.

## TABLE 2

| Figure No. | Symbols | | Lp(μm) | Nn(cm$^{-3}$) |
|------------|---------|----|--------|---------------|
| 6 | A | ● | 2 | $1\times10^{14}$ |
|   |   | o | 2 | $1\times10^{15}$ |
|   | B |   | 1 | $1\times10^{14}$ |
| 7 | A |   | 2 | $1\times10^{14}$ |
|   | B |   | 1 | $1\times10^{14}$ |
| 8 | A |   | 2 | $1\times10^{14}$ |
|   | B |   | 2 | $1\times10^{15}$ |

In view of those Figures, it is found that the forward voltage drop can be reduced, the backward restoration can be accelerated and the backward restoration characteristics can be made soft (in other words, the rate $di_R/dt$ can be decelerated) by reducing the surface impurity concentration. If the second p-type layer portion 32 is made to have a thickness of 1 to 2 μm and a surface impurity concentration of $1\times10^{15}$ to $1\times10^{16}$ cm$^{-3}$, for example, the forward voltage drop, the backward restoration time $t_{rr}$ and the backward restoration current reduction rate $di_R/dt$ can be reduced to 0.68 to 0.69 V, 35 to 40 ns, and 12 to 20 A/μs, respectively, thereby to provide a high-speed rectifier diode having a high performance. As the impurity concentration of the second p-type layer portion 32 is lowered, the positive holes are to be injected into the n-type layer 4 from the second p-type layer portion 32 in the forward bias state so that the current through the n-type layer 4 is a flow of the electrons acting as major carriers. As a result, the backward restoration time $t_{rr}$ is shortened. As the impurity concentration of the second p-type layer portion 32 is lowered, on the other hand, the diffusion potential at the pn junction is accordingly lowered to reduce the forward voltage drop.

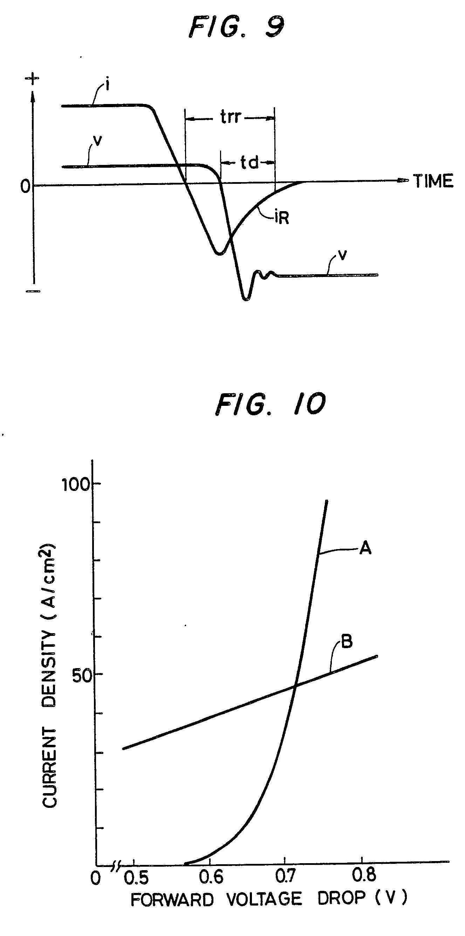

Here, a cursory description will be made upon the reduction rate $di_R/dt$. Fig. 9 illustrates the waveforms of a current i and a voltage v when the diode is reversed from its forward state. A backward restoration current $i_R$ flows, too, even after the bias has been reversed. Although it is not unimportant that the backward restoration current $i_R$ itself be small, it is important for the low power loss that the power loss (v×i) during the period, as indicated at $t_d$, be low. Especially large consideration should be taken into that power loss because this loss grows higher than any other loss during a high-frequency operation higher than about 50 Hz. For that importance, it is desired that the reduction rate $di_R/dt$ be low (in other words, to have soft recovery characteristics). Since the reduction rate $di_R/dt$ is low according to the present embodiment, the aforementioned power loss is so low that the present embodiment finds its suitable application in a switching regulator.

Next, the effects of the present embodiment will be described in the following in comparison with the Shottky barrier diode. Fig. 10 plots the relationship in the forward voltage drop and the forward current between the present embodiment (A) and the Shottky barrier diode (B). Here, the sample A corresponds to the case, in which Wch=3 μm, Nn=$1\times10^{14}$ cm$^{-3}$ and Nsp=$5\times10^{-3}$, and has its blocking voltage designed at 150 V. On the other hand, the sample B has its base layer thickness adjusted to have a blocking voltage of 150 V. In view of Fig. 10, the sample A exhibits a lower forward voltage drop than the sample B in the range where the current density in the forward direction is equal to or higher than about 50 A/cm$^2$. Within the range of the practically used current density (equal to or higher than 100 A/cm$^2$), therefore, the diode of the present embodiment has a lower loss than the Shottky barrier diode.

Although not illustrated, moreover, the diode of the present embodiment is far superior in the backward leakage current characteristics to the Schottky barrier diode.

Although the present invention has been described hereinbefore in connection with the representative example thereof, it should not be limited thereto but can be modified in various manners within the scope of the spirit thereof. The modifications conceivable are, for example:

(1) one in which the conduction types are reversed in the embodiment shown in the respective Figures;

(2) one in which the second p-type layer portion 32 is not arranged in the stripe shapes, as viewed from the one main surface 101, but in concentric, radial or matrix shaped and in their combined shapes.

## Claims

1. A semiconductor rectifier diode comprising a semiconductor substrate (100) having first and second major surfaces (102, 101), positioned at opposite sides of said substrate, including a first semiconductor layer (5, 51) of n-conductivity type disposed adjacent to said first major surface (102), a second semiconductor layer (4) of the n-conductivity type disposed adjacent to said first semiconductor layer (5, 51) and having a lower impurity concentration than said first semiconductor layer (5, 51), a third semiconductor layer (31) of p-conductivity type disposed adjacent to a selected portion of said second semiconductor layer (4) and formed in said second major surface (101), said third semiconductor layer (31) further having a higher impurity concentration than said second semiconductor layer (4), and at least one fourth semiconductor layer (32) of the p-conductivity type disposed adjacent to said second semiconductor layer (4) and formed in said second major surface (101), having a smaller thickness in a direction normal to said second major surface (101) of said substrate (100) than said third semiconductor layer (31) and having higher impurity concentration than said second semiconductor layer (4) and a lower impurity concentration than of said third semiconductor layer (31), said fourth semiconductor layer (32) and those portions of said first and second semiconductor layers (5, 51, 4) which overlap said fourth semiconductor layer (32) in the direction normal to said major surfaces (101, 102) construct a major current passage (I), a first main electrode (2) disposed at said first major surface (102) and ohmically contacting with said first semiconductor layer (5, 51); and a second main electrode (1) disposed at said second major surface (101) and ohmically contacting with said third semiconductor layer (31) and said fourth semiconductor layer (32), characterized in that said fourth semiconductor layer (32) is surrounded by said third semiconductor layer (31) and has a width (Wch) such that the depletion layer extending mainly from a pn junction between said third semicondcutor layer (31) and said second semiconductor layer (4) pinches off said main current passage (I) when a negative voltage is applied to said second main electrode (1) relative to said first main electrode (2).

2. A semiconductor rectifier diode as set fourth in claim 1, wherein said fourth semiconductor layer (32) has a plurality of stripes juxtaposed in one direction.

## Patentansprüche

1. Halbleiter-Gleichrichterdiode mit einem Halbleitersubstrat (100) mit einer ersten und einer zweiten, auf gegenüberliegenden Seiten des Substrats angeordneten Hauptoberflächen (102, 101), das eine erste, an die erste Hauptoberfläche (102) angrenzend angeordnete Halbleiterschicht (5, 51) des n-Leitfähigkeitstyps, eine zweite, an die erste Halbleiterschicht (5, 51) angrenzend angeordnete Halbleiterschicht (4) das n-Leitfähigkeitstyps, die eine niedrigere Verunreinigungskonzentration als die erste Halbleiterschicht (5, 51) hat, eine dritte, an einen ausgewählten Teil der zweiten Halbleitershicht (4) angrenzend angeordnete Halbleiterschicht (31) des p-Leitfähigkeitstyps, die in der zweiten Hauptoberfläche (101) gebildet ist, welche dritte Halbleiterschicht (31) außerdem eine höhere Verunreinigungskonzentration als die zweite Halbleiterschicht (4) hat, und wenigstens eine vierte Halbleiterschicht (32) des p-Leitfähigkeitstyps enthält, die an die zweite Halbleiterschicht (4) angrenzend angeordnet und in der zweiten Hauptoberfläche (101) gebildet ist, eine geringere Dicke in einer zur zweiten Hauptoberfläche (101) des Substrats (100) senkrechten Richtung als die dritte Halbleiterschicht (31) hat und eine höhere Verunreinigungskonzentration als die zweite Halbleiterschicht (4) und eine niedrigere Verunreinigungskonzentration als die dritte Halbleiterschicht (31) hat, wobei die vierte Halbleiterschicht (32) und solche Teile der ersten und zweiten Halbleiterschichten (5, 51, 4), die die vierte Halbleiterschicht (32) in der zu den Hauptoberflächen (101, 102) senkrechten Richtung überlappen, eine Hauptstrombahn (I) bilden, einer ersten Hauptelektrode (2), die an der ersten Hauptoberfläche (102) angeordnet ist und die erste Halbleiterschicht (5, 51) ohmisch kontaktiert, und einer zweiten Hauptelektrode (1), die an der zweiten Hauptoberfläche (101) angeordnet ist und die dritte Halbleiterschicht (31) und die vierte Halbleiterschicht (32) ohmisch kontaktiert, dadurch gekennzeichnet, daß die vierte Halbleiterschicht (32) von der dritten Halbleiterschicht (31) umgeben wird und eine derartige Breite (Wch) hat, daß die Verarmungsschicht, die sich hauptsächlich von einem pn-Übergang zwischen der dritten Halbleiterschicht (31) und der zweiten Halbleiterschicht (4) erstreckt, die Hauptstrombahn (I) abschnürt, wenn eine negative Spannung an die zweite Hauptelektrode (1) relativ zur ersten Hauptelektrode (2) angelegt wird.

2. Halbleiter-Gleichrichterdiode nach Anspruch 1, wobei die vierte Halbleiterschicht (32) eine Mehrzahl von in einer Richtung nebeneinanderliegenden Streifen aufweist.

## Revendications

1. Diode redresseuse à semiconducteurs comportant un substrat semiconducteur (100) possédant des première et seconde surfaces principales (102, 101), disposées sur des côtés opposés dudit substrat, comprenant une première couche semi-conductrice (5, 51) de conductivité de type n disposée adjacente à ladite première surface principale (102), une seconde couche semiconductrice (4) de conductivité de type n disposée adjacente à ladite première couche semiconductrice (5, 51) et possédant une concentration en impuretés inférieure à ladite première couche semiconductrice (5, 51), une troisième couche semiconductrice (31) de conductivité de type p disposés adjacente à une partie choisie de ladite seconde couche semiconductrice (4) et formée dans ladite seconde surface principale (101), ladite troisième couche semiconductrice (31) possédant en outre une concentration en impuretés supérieure à ladite seconde couche semiconductrice (4), et au moins une quatrième couche semiconductrice (32) de conductivité de type p disposée adjacente à ladite seconde couche semiconductrice (4) et formée dans ladite seconde surface principale (101), possédant une épaisseur inférieure dans une direction normale à ladite seconde surface principale (101) dudit substrat (100) à ladite troisième couche semiconductrice (31) et possédant une concentration en impuretés supérieure à ladite seconde couche semiconductrice (4) et une concentration en impuretés inférieure à ladite troisième couche semiconductrice (31), ladite quatrième couche semiconductrice (32) et les parties desdites première et seconde couches semiconductrices (5, 51, 4) qui recouvrent ladite quatrième couche semi-conductrice (32) dans la direction normale auxdites surfaces principales (101, 102) constituent un passage de courant principal (I),

une première électrode pincipale (2) disposée sur ladite première surface principale (102) et en contact ohmique avec ladite première couche semiconductrice (5, 51); et

une seconde électrode principale (1) disposée sur ladite seconde surface principale (101) et en contact ohmique avec ladite troisième couche semiconductrice (31) et ladite quatrième couche semiconductrice (32), caractérisée en ce que

ladite quatrième couche semiconductrice (32) est entourée par ladite troisième couche semiconductrice (31) et possède une largeur (Wch) de telle sorte que la couche d'épuisement s'étendant principalement depuis une jonction pn entre ladite troisième couche semiconductrice (31) et ladite seconde couche semiconductrice (4) rétrécit ledit passage de courant principal (1) lorsqu'une tension négative est appliquée à ladite seconde électrode principale (1) par rapport à ladite première électrode principale (2).

2. Diode redresseuse à semiconducteurs selon la revendication 1, dans lequelle ladite quatrième couche semiconductrice (32) possède une pluralité de bandes juxtaposées dans une direction.

## FIG. 1

## FIG. 2

## FIG. 3

## FIG. 4

## FIG. 5

## FIG. 6

## *FIG. 7*

## *FIG. 8*

## FIG. 9

## FIG. 10